(19) Europäisches Patentamt
European Patent Office
Office européen des brevets

(11) **EP 1 186 956 B1**

(12) **EUROPÄISCHE PATENTSCHRIFT**

(45) Veröffentlichungstag und Bekanntmachung des Hinweises auf die Patenterteilung:
**05.10.2011 Patentblatt 2011/40**

(51) Int Cl.:
***G03F 7/20*** *(2006.01)*

(21) Anmeldenummer: **01116995.0**

(22) Anmeldetag: **12.07.2001**

(54) **Projektionsbelichtungsanlage**

Projection exposure apparatus

Appareil d' exposition par projection

(84) Benannte Vertragsstaaten:
**AT BE CH CY DE DK ES FI FR GB GR IE IT LI LU MC NL PT SE TR**

(30) Priorität: **02.09.2000 DE 10043315**

(43) Veröffentlichungstag der Anmeldung:
**13.03.2002 Patentblatt 2002/11**

(73) Patentinhaber: **Carl Zeiss SMT GmbH**
**73447 Oberkochen (DE)**

(72) Erfinder: **Antoni, Martin**
**73434 Aalen (DE)**

(74) Vertreter: **Ostertag, Ulrich et al**
**Patentanwälte**
**Ostertag & Partner**
**Epplestr. 14**
**70597 Stuttgart (DE)**

(56) Entgegenhaltungen:
**EP-A- 0 938 031    JP-A- 9 190 969**
**US-A- 5 329 336    US-A- 5 396 311**
**US-A- 5 473 412**

**Beschreibung**

Die Erfindung betrifft eine Projektionsbelichtungsanlage nach dem Oberbegriff des Anspruchs 1.

Aus der US 5 264 898 A ist eine Projektionsbelichtungsanlage bekannt, bei der ein dort eingesetztes Filter Filterelemente aufweist, die das Projektionslicht bereichsweise vollständig blocken und in anderen Bereichen vollständig durchlassen. Das Filter soll dazu eingesetzt werden, die Fokallänge der Beleuchtungsoptik in der Objektebene unter Beibehaltung der Auflösung der Projektionsbelichtungsanlage zu optimieren.

Insbesondere bei Projektionsaufgaben, bei denen dreidimensionale Strukturen projiziert werden sollen, also z. B. bei der Übertragung von dreidimensionalen Strukturen von einem Retikel auf einen Wafer im Rahmen der Mikro-Lithographie, hat sich herausgestellt, dass es neben einer möglichst homogenen Beleuchtung der Objektebene auf eine wohldefinierte Verteilung der Beleuchtungswinkel in der Objektebene, d. h. der Winkel, unter denen das Projektionslicht auf die Objektebene auftrifft, ankommt. Die einzustellende Beleuchtungswinkelverteilung hängt davon ab, wie die Strukturen auf dem Retikel angeordnet sind und welche Ausdehnung sie senkrecht zur Objektebene aufweisen. Für unterschiedliche Retikel-Strukturen können sich daher unterschiedliche vorzugebende Beleuchtungswinkelverteilungen zur optimalen Projektion ergeben.

Würde man das Filter der US 5 264 898 A, dessen Einsatzzweck, wie oben beschrieben, in eine andere Richtung geht, zur definierten Vorgabe von Beleuchtungswinkeln einsetzen, könnte man damit zwar Beleuchtungswinkel vorgeben, hätte aber keine Möglichkeit, die Beleuchtungswinkelverteilung noch zusätzlich zu beeinflussen

Aus der US 5 329 336 A ist ein Beleuchtungssystem für eine Projektionsbelichtungsanlage bekannt, bei dem sich unterschiedliche Intensitätsfilter in den Strahlengang einführen lassen. Die Einzelfilter sind zu diesem Zweck auf einer drehbar gelagerten Platte derart angeordnet, daß sie einzeln in der Art einer Revolverzuführung in den Strahlengang eingeführt werden können. Die Einzelfilter sind dabei als lichtundurchlässige Platten ausgebildet, die eine oder mehrere Öffnungen unterschiedlicher Geometrie enthalten.

Aus der EP 0 938 031 A1 ist ein Filterelement für ein Beleuchtungssystem einer mikrolithographischen Projektionsbelichtungsanlage bekannt, das mehrere ringförmige Abschnitte aufweist. Die Abschnitte haben dabei unterschiedliche Transmissionskoeffizienten, die beispielsweise 40 %, 80 % oder 100 % betragen können.

Aus der JP 09 190969 A ist eine Projektionsbelichtungsanlage bekannt, in deren Beleuchtungssystem und pupillennah zwei Keilscheiben angeordnet sind, die zueinander verdreht werden können. Die beiden Scheiben tragen auf jeweils einer Seite eine Beschichtung, deren Transmissionsvermögen vom Einfallswinkel des auftreffenden Lichts abhängt. Durch Rotation einer der beiden Scheiben ändern sich die Winkelverhältnisse an den geneigten Grenzflächen für ein durchtretendes Strahlenbündel. In Folge der Winkelabhängigkeit des Transmissionsvermögens wird dann bei einer bestimmten Drehstellung ein Punkt in einer Feldblendenebene stärker und ein diametral gegenüberliegender Punkt schwächer beleuchtet. In Folge der ortsabhängig variierente Dicke der Keilscheiben ist auch deren Transmissionsgrad auch für gleiche Winkel nicht vollkommen ortsunabhängig.

Es ist daher die Aufgabe der vorliegenden Erfindung, eine Projektionsbelichtungsanlage der eingangs genannten Art derart weiterzubilden, dass eine vorgegebene Beleuchtungswinkelverteilung möglichst präzise eingestellt werden kann.

Diese Aufgabe wird erfindungsgemäß durch eine Projektionsbeleichtungsanlage mit den im Anspruch 1 angegebenen Merkmalen gelöst.

Mit einem ein derartiges Filterelement aufweisenden Filter in der Filterebene stehen nun mit dem Bewegungsfreiheitsgrad, z.B. einer Translation oder einer Rotation des Filterelements, und der zumindest bereichsweisen Teildurchlässigkeit zwei Freiheitsgrade zur Verfügung, mit Hilfe des Filters aus einer gegebenen Projektionslichtverteilung durch Einstellung der entsprechenden Transmission im Bereich einer Pupillenebene vor der Objektebene die gewünschwünschte Beleuchtungswinkelverteilung in der Objektebene zu erzeugen. Ein Wechsel der zu projizierenden Objektstruktur oder Änderungen in der Beleuchtung, die im Laufe des Betriebs der Projektionsbelichtungsanlage auftreten, können durch Nachstellen des beweglichen Filterelements ausgeglichen werden. Alternativ oder zusätzlich kann mit dem beweglichen Filterelement eine Feineinstellung eines schon anderweitig vorgegebenen Beleuchtungssettings, also einer Vorgabe der Beleuchtungswinkel z.B. durch eine entsprechende Aperturblende, vorgenommen werden.

Der Transmissionsgrad des Filterelements ist erfindungsgemäß über die Filterfläche bezüglich der optischen Achse der Projektionsoptik nicht rotationssymmetrisch. Ferner ist das Filterelement derart gehalten, dass es um die optische Achse verdreht werden kann. Mit einem Filter, das ein derartiges Filterelement aufweist, lässt sich durch Verdrehung des Filterelements bei einem Wechsel des Retikels eine Anpassung der Beleuchtungswinkelverteilung an den eingesetzten Retikeltyp, also die zu projizierende Objektstruktur, vornehmen. Zusätzlich lassen sich Änderungen in der Beleuchtung korrigieren, die sich in einer Rotation einer zur optischen Achse nicht rotationssymmetrischen Verteilung der Beleuchtungsintensität in der Pupillenebene niederschlagen. Entsprechend der Rotation dieser Intensitätsverteilung wird das um die optische Achse drehbare Filterelement nachgestellt, so daß die Intensitätsverteilung nach dem Filter entsprechend einer vorgegebenen Verteilung, die einer Beleuchtungswinkelverteilung entspricht, unverändert bleibt. Derartige Änderungen der Beleuchtungsintensitätsverteilung in der Pupillenebene können sich beispielsweise aus zeitlichen Drifts der Eigenschaften der Lichtquelle oder der optischen Eigenschaften der Beleuchtungsoptik ergeben. Auch eine Justage der Lichtquelle oder der Beleuchtungsoptik oder eine Änderung des Beleuchtungssettings kann eine derartige Rotation der Beleuchtungsintensitätsverteilung bewirken.

Mit der Steuereinrichtung, die erfindungsgemäß mit der Antriebseinrichtung zusammenarbeitet, lässt sich beispielsweise abhängig von einer vorliegenden Information über die Retikelstruktur oder über den Justagezustand der Lichtquelle bzw. der Beleuchtungsoptik das Filter automatisch ein- oder nachstellen.

Die erfindungsgemäße Detektoreinrichtung ermöglicht eine Nachführung der Beleuchtungwinkelverteilung durch ein entsprechendes Nachfahren des beweglichen Filterelements abhängig von der detektierten Intensitätsverteilung.

Das Filter kann mindestens ein Filterelement mit in zur optischen Achse radialer Richtung variierendem Transmissiongrad aufweisen. Dies ergibt die Möglichkeit, mit dem Filter Bereiche mit verschiedenem Abstand zur optischen Achse unterschielich zu beeinflussen. Damit lassen sich auch komplexere Beleuchtungswinkelverteilungen ein- bzw. nachstellen.

Das Filter kann ein kontinuierlicher Verlaufsfilter sein. Mit derartigen Filtern mit mindestens einem Filterelement mit sich stetig änderndem Transmissionsgrad lassen sich entsprechende stetige Beleuchtungswinkelverteilungen erzeugen.

Alternativ kann das Filterelement mindestens zwei Zonen mit unterschiedlichem Transmissionsgrad aufweisen. An den Zonengrenzen kann es hier zu einem stufenförmigen Verlauf des Transmissionsgrades kommen. Innerhalb der Zonen kann die Transmission konstant sein oder wiederum einen kontinuierlichen Verlauf haben. Eine derartige Aufteilung in Zonen erleichtert die definierte Vergabe bzw. die definierte Nachstellung einer Beleuchtungswinkelverteilung.

Bevorzugt ist die freie Apertur der Beleuchtungsoptik in der Filterebene kreisförmig und das Filter weist mindestens ein Filterelement mit einer Mehrzahl von Zonen mit in Umfangsrichtung unterschiedlichem Transmissionsgrad auf. Mit derartigen Filterelementen ist beispielsweise eine Beleuchtungswinkelverteilung mit mehrzähliger Symmetrie einstellbar.

Das Filterelement kann mindestens zwei Zonen mit in radialer Richtung unterschiedlichem Transmissionsgrad aufweisen. Auch hier erleichtert die Aufteilung in Zonen die definierte Vorgabe bzw. das definierte Nachstellen einer Beleuchtungswinkelverteilung. Liegt eine Unterteilung in Zonen sowohl in Umfangsrichtung als auch in radialer Richtung vor, ist die Freiheit bei der Einstellung einer Beleuchtungswinkelverteilung besonders groß.

Das Filterelement kann vier Quadranten mit in Umfangsrichtung abwechselndem Transmissionsgrad aufweisen. Mit einem derartigen Filterelement ist eine Beleuchtungswinkelverteilung, die eine zweizählige Symmetrie, d. h. eine sog. Elliptizität, aufweist, mit vorgegebener Orientierung der Ellipse einstellbar. Alternativ oder zusätzlich kann ein derartiges Filterelement dazu herangezogen werden, bereits existierende Elliptizitäten auszugleichen. Derartige Elliptizitäten können sich z. B. aufgrund der Geometrie der Lichtquelle bzw. der Beleuchtungsoptik oder auch aufgrund eines schon anderweitig voreingestellten Beleuchtungssettings ergeben.

Vorzugsweise weist das Filter mindestens zwei Filterelemente auf, die derart gehaltert sind, dass sie relativ zueinander verdreht werden können. Die dadurch gegebene Verteilung des Gesamttransmissionsgrads auf zwei Filterelemente vergrößert nochmals die Freiheit vorgeb- bzw. nachstellbarer Beleuchtungswinkelverteilungen.

Dabei kann in einer Relativstellung der Filterelemente ein rotationssymmetrischer Transmissionsgrad des Filters resultieren. Damit existiert eine Stellung des beweglichen Filterelements, bei dem das Filter, zumindest was den Einfluss auf die Rotationssymmetrie angeht, neutral wirkt.

Auf einfache Weise können so die Rotationssymmetrie-Eigenschaften der Beleuchtungswinkelverteilung ohne Filtereinfluss bei eingebautem Filter geprüft oder genutzt werden. Insbesondere können die Filterelemente so ausgestaltet sein, dass der Transmissionsgrad in einer Relativstellung der Filterelemente über die ganze Filterfläche konstant ist, so dass der Filtereinfluss auf die Beleuchtungswinkelverteilung, z. B. zu Prüfzwecken, vollständig eliminiert werden kann.

Die Detektoreinrichtung kann ein zweidimensionales CCD-Array aufweisen. Eine derartige Detektoreinrichtung weist eine hohe Positionsauflösung auf und ist lichtempfindlich.

Die Detektoreinrichtung kann so ausgeführt sein, dass sie die Beleuchtungswinkelverteilung des Projektionslichts in der Objektebene ermittelt. Die direkt gemessene Beleuch tungswinkelverteilung ist die ideale Eingangsgröße für eine Nachregelung mit Hilfe des beweglichen Filterelements.

Ausführungsbeispiele der Erfindung werden nachfolgend anhand der Zeichnung näher erläutert; es zeigen:

Figur 1        eine schematische Übersicht einer Pro- jektionsbelichtungsanlage;

Figuren 2-4    Ausführungsbeispiele von Filterelementen eines erfindungsgemäßen Filters für die Projektionsbelichtungsanlage von Figur 1;

Figur 5        eine schematische Darstellung eines Fil- ters mit einem stationären und einem dreh- baren Filterelement gemäß Figur 2;

Figuren 6-8    Ausführungsbeispiele von Filtern mit zwei gegeneinander verdrehbaren Filterelementen in Aufsicht in verschiedenen Relativwinkel- positionen.

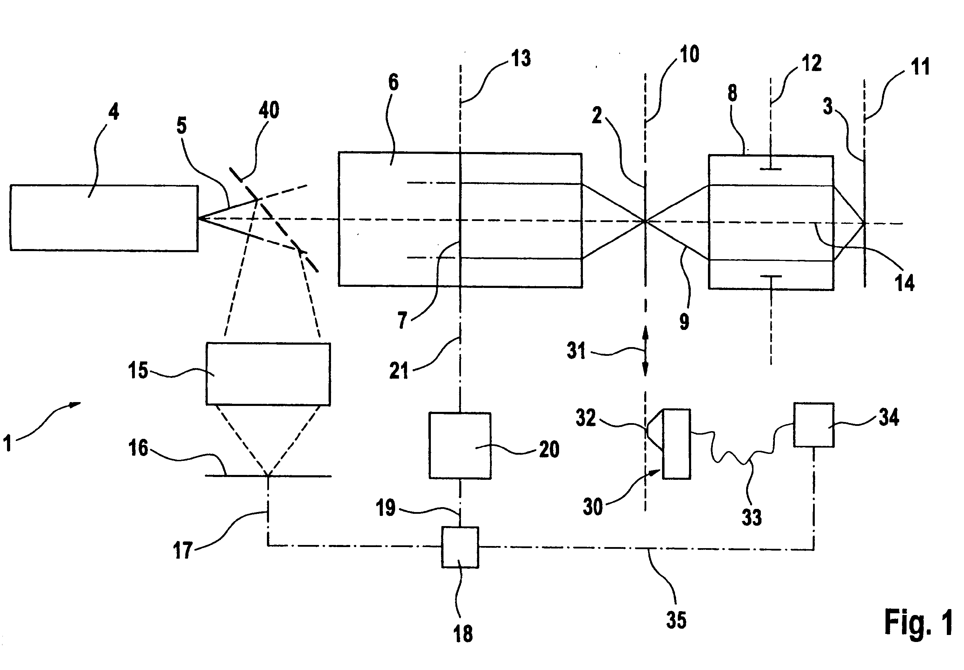

In Figur 1 ist eine insgesamt mit dem Bezugszeichen 1 versehene Projektionsbelichtungsanlage für die Mikrolithographie dargestellt. Mit dieser wird eine Struktur auf einem Retikel 2 auf die Oberfläche eines Wafers 3 übertragen.

Als Lichtquelle für die Projektionsbelichtungsanlage 1 dient ein UV-Laser 4, z.B. ein ArF-Excimerlaser mit einer Wellenlänge von 193,3 nm. Ein von diesem emittiertes Projektionslichtbündel 5 tritt zunächst in eine Beleuchtungsoptik 6 ein. Der Strahlengang des Projektionslichtbündels 5 ist der Übersichtlichkeit wegen nur zwischen dem UV-Laser 4 und der Beleuchtungsoptik 6 angedeutet. Die Beleuchtungsoptik 6 ist in Figur 1 schematisch als Block dargestellt und kann eine Reihe optischer Baugruppen, z. B. ein Zoom-Objektiv, diffraktive optische Elemente und einen Glasstab zur Homogenisierung des Projektionslichtbündels 5 aufweisen.

Beim Durchtritt durch die Beleuchtungsoptik 6 passiert das Projektionslichtbündel 5 ein in einer Pupillenebene 13 angeordnetes Pupillenfilter 7, welches noch im Detail beschrieben wird. Die Pupillenebene 13 wird nachfolgend auch Filterebene genannt. Anschließend beleuchtet das Projektionslichtbündel 5 das Retikel 2. Die Strukturen des Retikels 2 werden mit Hilfe einer Projektionsoptik 8 auf die Oberfläche des Wafers 3 projiziert. Die Projektionsoptik 8 kann aus einer Mehrzahl von Linsen und/oder Spiegeln aufgebaut sein.

Ein ausgewähltes, einen zentralen Objektpunkt auf dem Retikel 2 passierendes und mit der Projektionsoptik 8 geführtes Abbildungslichtbündel ist in Figur 1 mit dem Bezugszeichen 9 versehen und zur Verdeutlichung des Abbildungsstrahlengangs ein Stück weit in Gegenrichtung, also in Richtung auf die und in die Beleuchtungsoptik 6 verlängert. Das Retikel 2 liegt in der Objektebene 10 der Projektionsoptik 8, die in Figur 1 durch eine gestrichelte Linie angedeutet ist. Der Wafer 3 liegt in einer ebenfalls durch eine gestrichelte Linie angedeuteten Bildebene 11 der Projektionsoptik 8. Eine Pupillenebene 12 der Projektionsoptik 8 ist in Figur 1 ebenfalls schematisch angedeutet. Sie ist zur Filterebene 13 in der Beleuchtungsoptik 6 konjugiert.

Die optische Achse der Projektionsbelichtungsanlage 1 ist in Figur 1 ebenfalls gestrichelt angedeutet und mit dem Bezugszeichen 14 versehen.

Im Strahlengang zwischen dem UV-Laser 4 und der Beleuchtungsoptik 6 ist eine teildurchlässige optische Platte 40 angeordnet, die einen geringen Anteil des Projektionslichtbündels 5 reflektiert und den überwiegenden Anteil, in der Praxis mehr als 99%, dieses Lichtbündels transmittiert. Der Strahlengang des die optische Platte 40 durchtretenden Projektionslichtbündels 5 ist, da er hier nicht weiter interessiert, nur noch ein Stück weit gestrichelt fortgesetzt.

Der reflektierte, ebenfalls gestrichelt dargestellte Anteil des Projektionslichtbündels 5 nach der optischen Platte 40 wird mittels einer Abbildungsoptik 15 auf ein zweidimensionales CCD-Array 16 abgebildet. Letzteres steht über eine strichpunktiert dargestellte Signalleitung 17 mit einer Steuereinrichtung 18 in Verbindung. Die Steuereinrichtung 18 steuert über eine Signalleitung 19, die ebenfalls strichpunktiert dargestellt ist, eine Antriebseinrichtung 20 an, die über eine ebenfalls strichpunktiert dargestellte Antriebsverbindung 21 eine Verdrehung eines Elements des Pupillenfilters 7 um die optische Achse 14 bewerkstelligt, wie noch beschrieben werden wird.

Eine alternativ oder zusätzlich zum CCD-Array 16 einsetzbare Detektionseinrichtung 30 zur Messung der Beleuchtungsintensitäts- und der Beleuchtungswinkelverteilung des Abbildungsbündels 9 in der Objektebene 10, ist in Figur 1 in einer inaktiven Stellung außerhalb des Projektionsstrahlengangs dargestellt. Mittels einer nicht dargestellten Antriebseinrichtung kann die Detektionseinrichtung 30 senkrecht zur optischen Achse 14, wie durch den Doppelpfeil 31 dargestellt, nach Entfernen des Retikels 2 derart in den Strahlengang der Optik eingeschoben werden, daß eine Eintrittsöffnung 32 in der Objektebene 10 liegt, durch welche ein normalerweise das Retikel beleuchtendes Abbildungsbündel, z.B. das Abbildungsbündel 9, in das Innere der Detektionseinrichtung 30 eintreten kann.

Die Detektionseinrichtung 30 ist über eine flexible Signalleitung 33 mit einer Steuereinrichtung 34 verbunden, die ihrerseits über eine strichpunktiert dargestellte Signalleitung 35 mit der Steuereinrichtung 18 in Verbindung steht.

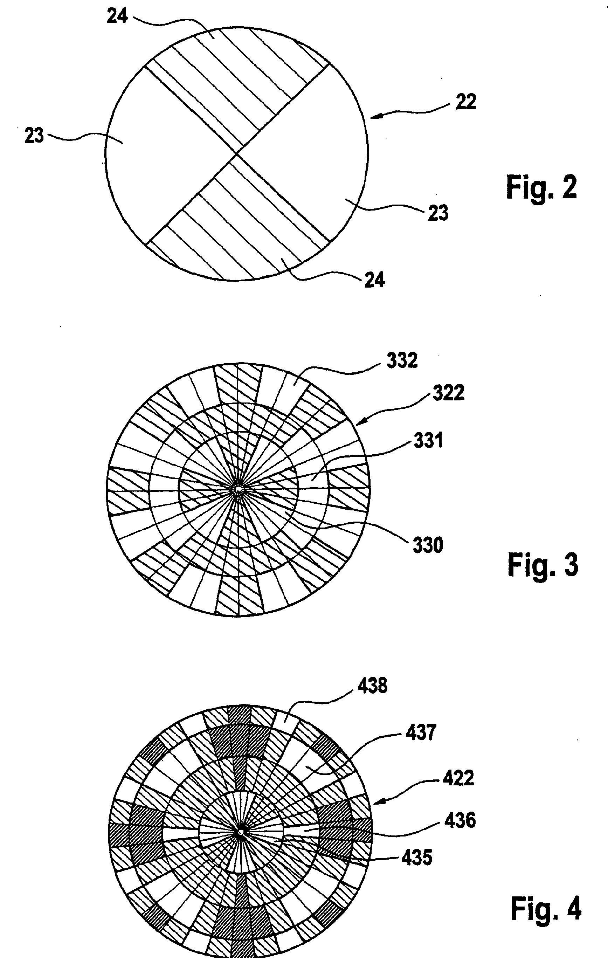

Nachfolgend wird anhand der Figuren 2, 5 und 6 der Aufbau eines ersten Ausführungsbeispiels eines Pupillenfilters beschrieben:

Das Pupillenfilter 7 weist zwei gleich aufgebaute Filterelemente 22, 22' auf, wie sie in Figur 2 dargestellt sind. Die dortige Aufsicht zeigt, dass das Filterelement 22 in 4 Quadranten unterteilt ist. Der Transmissionsgrad des Filterelements 22 ist innerhalb jedes Quadranten konstant. Die Transmissionsgrade der einzelnen Quadranten wechseln in Umfangsrichtung derart ab, dass die Transmissionsgrade gegenüberliegender Quadranten gleich groß sind. Zwei einander gegenüberliegende Quadranten lassen das Projektionslicht vollständig durch und sind in der Figur 2 mit dem Bezugszeichen 23 versehen. Sie werden nachfolgend "Transmissionsquadranten" genannt. Die beiden anderen Quadranten lassen das Projektionslicht nur teilweise, z. B. zu 50% durch und sind in Figur 2 schraffiert und mit dem Bezugszeichen 24 versehen. Sie werden nachfolgend "Absorptionsquadranten" genannt. Anstelle von absorbierenden Quadranten oder Zonen können dort, wo keine vollständige Transmission gewünscht ist, auch teilreflektierende Bereiche vorgesehen sein.

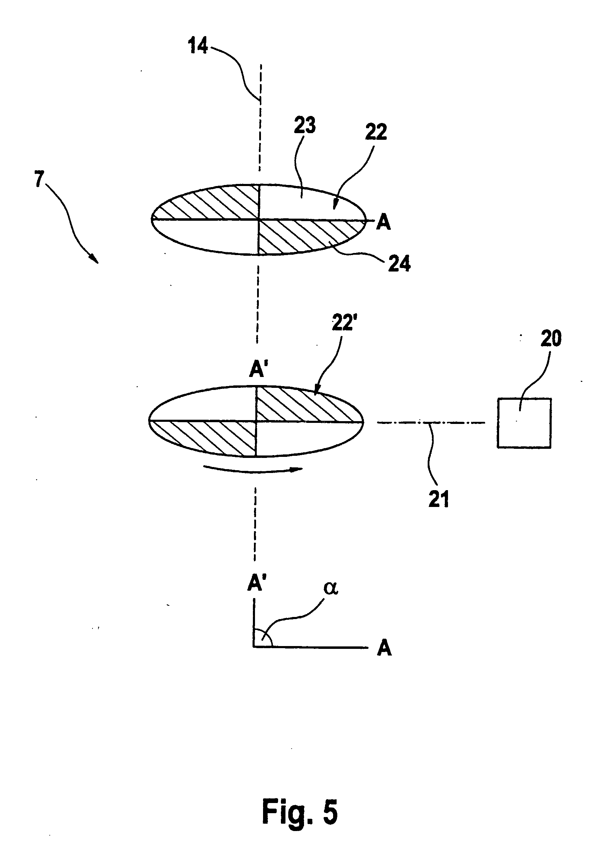

Den Aufbau des Pupillenfilters 7 verdeutlicht die schematische Darstellung von Figur 5. Die beiden Filterelemente 22 sind so einander benachbart parallel angeordnet, daß die optische Achse 14 durch das Zentrum der beiden Filterelemente 22 geht. Das in Figur 5 obere Filterelement 22 ist stationär, während das untere Filterelement, das das Bezugszeichen 22' trägt, mittels der Antriebseinrichtung 20 um die optische Achse 14 drehbar ist.

Eine Trennlinie zwischen den Transmissionsquadranten 23 und den Absorptionsquadranten 24 des stationären Filterelements 23 ist zu Beschreibungszwecken mit dem Buchstaben A markiert. Das drehbare Filterelement 22' ist in Fig. 5 gegenüber dem stationären Filterelement 22 derart verdreht, daß die der Trennlinie A des stationären Filterelements 22 entsprechende Trennlinie A' auf dem drehbaren Filterelement 22' entgegen dem Uhrzeigersinn um 90° verdreht ist. In Figur 5 unten ist dieser Verdrehwinkel, der im Folgenden als Relativwinkel $\alpha$ bezeichnet wird, nochmals mit den Markierungen A, A' der einander entsprechenden Trennlinien schematisch dargestellt.

Alternativ zu einer Verdrehung um die optische Achse (nicht Teil der Erfindung) kann auch eine Translation eines beweglichen Filterelements in der Filterebene vorgesehen sein.

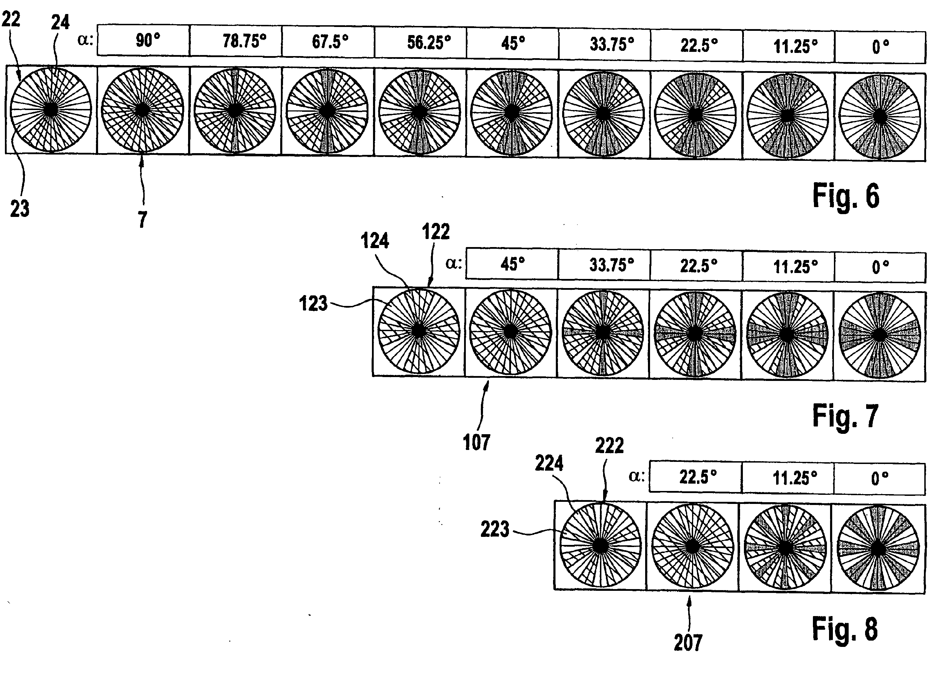

In der Figur 6 sind die übereinanderliegenden Filterelemente 22, 22' des Pupillenfilters 7 in verschiedenen Relativwinkelpositionen gezeigt. Ganz links in Figur 6 ist das einzelne Filterelement 22 nochmals der Anschaulichkeit halber dargestellt. Die auch in den weiteren Einzeldarstellungen der Figuren 7 und 8 erfolgte Unterteilung der Filterelemente in insgesamt 32 Sektoren dient nur zur Veranschaulichung der Gesamtabsorptionsänderungen des jeweiligen Pupillenfilters bei Änderung des Relativwinkels und hat keine körperliche Entsprechung auf den Filterelementen.

Die in der Figur 5 schon dargestellte Relativwinkelposition mit einem Relativwinkel $\alpha$ von 90° ist in der Figur 6 in der zweiten Einzeldarstellung von links gezeigt. Die Gesamttransmission des Pupillenfilters 7 ist über die gesamte Filterfläche konstant und entspricht dem Transmissionsgrad eines Absorptionsquadranten 24.

In der Folge von Einzeldarstellungen, die auf die dem Relativwinkel 90° entsprechenden Einzeldarstellung folgen, ist gezeigt, wie sich der Gesamttransmissionsgrad über die Filterfläche des Pupillenfilters 7 ändert, wenn das drehbare Filterelement 22' gegenüber dem stationären Filterelement 22 aus der Stellung mit Relativwinkel $\alpha$ = 90° in Schritten von 11,25° in die Stellung $\alpha$ = 0° zurückgedreht wird.

Bei der Relativwinkelposition 78,75° überlappen in einer sektorförmigen Zone, die einem Achtel eines Quadranten eines Filterelements 22 entspricht, die beiden Absorptionsquadranten 24 und, um 90° versetzt, die beiden Transmissionsquadranten 23. Dort, wo die Absorptionsquadranten 24 überlappen, ist die Gesamtabsorption des Pupillenfilters 7 doppelt so hoch wie die Absorption eines Absorptionsquadranten 24 eines Filterelements 22 alleine. Dort, wo die beiden Transmissionsquadranten 23 überlappen, wird hingegen das Projektionslicht vollständig durchgelassen. Im übrigen Bereich der Filterfläche hat der Pupillenfilter 7 die Transmission des Absorptionsquadranten 24 eines Filterelements 22.

Wie aus der weiteren Abfolge der Einzeldarstellungen von Figur 6 hervorgeht, verbreitern sich beim weiteren Zurückdrehen des drehbaren Filterelements 22' gegenüber dem stationären Filterelement 22 die sektorförmigen Zonen, in denen die Gesamtabsorption verdoppelt ist bzw. vollständiger Durchlaß erfolgt. Gleichzeitig verkleinern sich die sektorförmigen Zonen, in denen eine Gesamttransmission des Pupillenfilters 7 vorliegt, die der Transmission eines Absorptionsquadranten 24 entspricht.

Schließlich liegt beim Relativwinkel 0 Grad die Situation vor, in der die beiden Filterelemente 22, 22' deckungsgleich übereinander liegen. Dadurch ergibt sich eine Transmissionsverteilung des Pupillenfilters 7 über die Filterfläche, die derjenigen eines einzelnen Filterelements 22 entspricht, wobei allerdings die Gesamtabsorption des Pupillenfilters 7 im Bereich der Absorptionsquadranten 24 verdoppelt ist, da dort zwei Absorptionsquadranten 24 hintereinander im Strahlengang liegen.

Weitere Ausführungsbeispiele von Pupillenfiltern werden nachfolgend anhand der Fig. 7 und 8 beschrieben. Bauelemente, die solchen entsprechen, die schon im Zusammenhang mit früher beschriebenen Ausführungsbeispielen erläutert wurden, tragen um jeweils 100 erhöhte Bezugszeichen und werden nicht nochmals im einzelnen diskutiert.

Das Filterelement 122, das in der linken Einzeldarstellung der Figur 7 gezeigt ist, ist in insgesamt acht sektorförmige Zonen unterteilt, die jeweils über ihre Zonenfläche einen konstanten Transmissionsgrad aufweisen, wobei der Transmissionsgrad von aneinander angrenzenden Zonen in Umfangsrichtung abwechselt. Hierbei folgt in Umfangsrichtung auf eine Transmissionszone 123 jeweils eine Absorptionszone 124 und umgekehrt.

In den weiteren Einzeldarstellungen der Figur 7 sind die Gesamttransmissionen eines Pupillenfilters 107 in unterschiedlichen Relativwinkelpositionen dargestellt, das analog zum in Figur 5 dargestellten Pupillenfilter 7 zwei axial übereinander angeordnete Filterelemente 122 aufweist. Eines der beiden Filterelemente 122 ist gegenüber dem anderen, das stationär ist, verdrehbar. Die zweite Einzeldarstellung von links der Figur 7 zeigt die Situation, bei der die beiden Filterelemente 122 um einen Relativwinkel von 45° gegeneinander verdreht sind. Dabei liegen alle Absorptionszonen 124 des einen Filterelements genau hinter bzw. vor Transmissionszonen 123 des anderen Filterelements 122, so daß insgesamt ein homogener Transmissionsverlauf mit einem konstanten Gesamttransmissionsgrad über diese Fläche resultiert, analog zur Einzeldarstellung in Figur 6 mit dem Relativwinkel 90°.

In den weiteren Einzeldarstellungen der Figur 7 ist eine Abfolge gezeigt, die das schrittweise Zurückdrehen des drehbaren Filterelements in 11,25°-Schritten aus der Position mit $\alpha$ = 45° in die Position mit $\alpha$ = 0° zeigt. Hierbei

entsteht im ersten Schritt des Zurückdrehens ($\alpha$ = 33,75°) eine kreuzförmige Struktur aus vier jeweils um 90° gegeneinander versetzten sektorförmigen Zonen mit Sektorwinkel 11,25°, in denen die doppelte Absorption der einzelnen Absorptionszone 124 eines Filterelements 122 auftritt, und um 45° zu diesen versetzt eine ebenfalls kreuzförmige Struktur aus sektorförmigen Zonen mit gleichem Sektorwinkel, in denen keine Absorption erfolgt. In den übrigen Bereichen liegt eine Filtergesamttransmission vor, die der Transmission einer einzelnen Absorptionszone 124 entspricht. Beim weiteren Zurückdrehen des drehbaren Filterelements verbreitern sich die doppelt absorbierenden Zonen und auch die das Projektionslicht vollständig durchlassenden Zonen mit fortschreitendem Drehwinkel, bis bei $\alpha$ = 0° wieder die Situation auftritt, bei der der Transmissionsverlauf des Pupillenfilters 107 demjenigen eines einzelnen Filterelements 122 entspricht. Allerdings ist dabei die Absorption in den absorbierenden Zonen doppelt so hoch, wie diejenige einer einzelnen Absorptionszone 124.

Analog zu den Figuren 6 und 7 zeigt Figur 8 die Verhältnisse, bei einem weiteren Pupillenfilter 207. Dieses weist zwei Filterelemente 222 auf, wie sie in der linken Einzeldarstellung von Figur 8 gezeigt sind.

Ein Filterelement 222 weist insgesamt 16 jeweils einen Umfangswinkel von 22,5° einschließende sektorförmige Zonen 223, 224 auf. Jeweils auf eine Absorptionszone 224 folgt dabei in Umfangsrichtung eine Transmissionszone 223 und umgekehrt. Hier lässt sich durch Verdrehen des drehbaren Filterelements um einen Relativwinkel $\alpha$ von 22,5° wieder die Situation eines konstanten Transmissionsverlaufs über die gesamte Filterfläche herstellen (vgl. Figur 8, zweite Einzeldarstellung von links). Wird das drehbare Filterelement zurückgedreht, was auch in Figur 8 in Einzeldarstellungen in Schritten zu je 11,25° gezeigt ist, lässt sich hier eine achtzählige Struktur von Gesamtabsorptionszonen mit ggf. abgestuftem Absorptionskoeffizienten mit einer dazwischenliegenden achtzähligen Struktur von Gesamttransmissionszonen erzeugen.

Die Figuren 3 und 4 zeigen weitere Ausführungsbeispiele von Filterelementen:

Auch in den Figuren 3 und 4 sind die Filterelemente zu Beschreibungszwecken in jeweils 32 Sektoren unterteilt, die dort, wo zu beiden Seiten einer Sektorgrenze gleiche Transmission herrscht, keine körperliche Entsprechung haben.

Das Filterelement 322, das in Figur 3 gezeigt ist, weist insgesamt drei konzentrische Abschnitte 330, 331 sowie 332 auf, die jeweils in Umfangszonen mit abwechselnden Transmissionen unterteilt sind:

Der innerste Umfangsabschnitt weist einen Transmissionsverlauf auf, der in Umfangsrichtung demjenigen des Filterelements 122 von Figur 7 entspricht. Der mittlere Abschnitt 331 weist in Umfangsrichtung einen Transmissionsverlauf auf, der demjenigen des Filterelements 22 der Figuren 2 und 6 entspricht. Der äußerste Abschnitt 332 wiederum weist einen Transmissionsverlauf auf, der demjenigen des Filterelements 222 von Figur 8 entspricht.

Das Filterelement 422, das in Figur 4 dargestellt ist, weist insgesamt vier konzentrische Abschnitte 435, 436, 437, 438 auf, die in Umfangsrichtung unterschiedliche Abfolgen von Zonen mit unterschiedlichem Transmissionsgrad besitzen.

Der innerste Abschnitt 435 hat hierbei einen Transmissionsverlauf, der demjenigen des Filterelements 122 von Fig. 7 entspricht.

Der ihn umschließende benachbarte Abschnitt 436 ist in Umfangsrichtung in Zonen mit drei verschiedenen Transmissionsgraden unterteilt. Hierbei wird in zwei Zonen, die einander gegenüberliegen und einen Umfangswinkel von 11,25° einschließen, das Projektionslicht vollständig durchgelassen, während zwei gegenüber diesen um 90° versetzte, ebenfalls einen Umfangswinkel von 11,25° einschließende Zonen einen Absorptionskoeffizienten aufweisen, der doppelt so hoch wie der Absorptionskoeffizient in der restlichen Zone des Abschnitts 436 ist.

Der Abschnitt 437, der dem Abschnitt 436 benachbart ist und diesen konzentrisch umgibt, ist ebenfalls in Zonen mit drei verschiedenen Transmissionsgraden unterteilt. Hierbei folgt in Umfangsrichtung einer Zone mit Umfangswinkel 33,75° und doppeltem Absorptionskoeffizienten zunächst eine Zone, die einen Umfangswinkel von 11,25° einschließt und einen einfachen Absorptionskoeffizienten aufweist. An diese schließt sich eine Zone an, die einen Umfangswinkel von 33,75° einschließt und vollständig durchlässig für Projektionslicht ist. Dieser folgt in Umfangsrichtung wiederum eine Zone, die einen Umfangswinkel von 11,25° einschließt und einen einfachen Absorptionskoeffizienten aufweist. Diese Sequenz wiederholt sich über den Umfang des Abschnitte 437 insgesamt viermal.

Der äußerste Abschnitt 438 schließlich weist ebenfalls drei verschiedene Absorptionskoeffizienten auf. Hier folgen jeweils Zonen, die einen Umfangswinkel von 11,25° einschließen, in der Abfolge "doppelter Absorptionskoeffizient, einfacher Absorptionskoeffizient, keine Absorption, einfacher Absorptionskoeffizient" insgesamt acht Mal aufeinander.

Die Filterelemente 22 bis 422 sind beliebig miteinander kombinierbar. Natürlich können auch mehr als zwei Filterelemente 22 bis 422 in axialer Richtung hintereinander gestaffelt angeordnet werden. Auch die Art der Unterteilung der Filterfläche in einzelne Transmissionsund Absorptionszonen und -abschnitte ist nicht durch die dargestellten Ausführungsbeispiele beschränkt. Ebensowenig ist die Anzahl der verschiedenen Absorptionsgrade pro Filterelement nicht auf drei beschränkt, sondern kann wesentlich größer sein. Schließlich können auch Filterelemente mit stufenlosen Transmissionsverläufen eingesetzt sein.

Mathematisch kann der Transmissionsgrad eines Filters mit kreisförmigen Filterelementen in allgemeiner Form folgendermaßen beschrieben werden:

Das Filter besteht hierbei aus n hintereinander liegenden Filterelementen, die jeweils m Umfangsabschnitte aufweisen. Der Transmissionsverlauf t eines Punktes innerhalb eines Umfangsabschnitts eines solchen Filterelements kann geschrieben werden als:

$$t_{ij}(r, \beta)$$

Hierbei sind:

i der Index für die Umfangsabschnitte, der von 1 bis m geht;

j der Index für die Filterelemente, der von 1 bis n geht;

r der Abstand des Punktes von der Filterachse; und

$\beta$ der Polarwinkel des Punktes, gemessen von einer festen Bezugsachse (z.B. Trennlinie A in Fig. 5).

Die Gesamttransmission T eines Umfangsabschnitts des Filters kann dann als Produkt der Transmissionsgrade der einzelnen Filterelemente beschrieben werden:

$$T_i(r, \beta) = \prod_{j=1}^{n} t_{ij}(r, \beta + \alpha_{ij})$$

Die Umfangsabschnitte $t_{ij}$ der Filterelemente sind hierbei um die Winkel $\alpha_{ij}$ (i=1...m, j=1...n) um die Ausgangslage verdreht.

Wenn in den einzelnen Filterzonen $t_{ij}$ keine radiale Abhängigkeit der Transmission vorliegt, kann vereinfacht geschrieben werden: $t_{ij}(r, \beta) = t_{ij}(\beta)$.

Im Fall eines kontinuierlichen Transmissionsverlaufs sind die hier beschriebenen Darstellungen stetig in r und ß. Alternativ können die Transmissionsverläufe aber auch diskret bzw. stufenförmig sein, wie oben im Zusammenhang mit den Figuren beschrieben.

Die Projektionsbelichtungsanlage 1 funktioniert folgendermaßen:

Abhängig von der Art der mit der Projektionsbelichtungsanlage 1 zu projizierenden Objektstruktur wird vorgegeben, wie das Intensitätsprofil des Projektionslichtbündels 5 in der Pupillenebene 13 aussehen soll.

Das gewünschte Intensitätsprofil des Projektionslichtbündels 5 in der Pupillenebene 13 kann z.B. ein konstanter Intensitätsverlauf über das Bündelprofil sein. Je nach abzubildender Struktur können aber auch beliebige andere Intensitätsverteilungen des Projektionslichtbündels 5 in der Pupillenebene 13, sog. Beleuchtungssettings, vorgegeben werden. Für bestimmte Strukturen eignet sich beispielsweise eine ringförmige Beleuchtung, d.h. ein Beleuchtungstyp, bei dem die Intensitätsverteilung in der Pupillenebene 13 in einem ringförmigen Bereich um die optische Achse 14 die größte Intensität aufweist. Je nach der Symmetrie der Struktur auf dem Retikel 2 sind auch andere Beleuchtungssettings zur optimalen Projektion einstellbar, z.B. mit mehrzähliger Symmetrie in Umfangsrichtung entsprechend den Absorptionsverläufen, die in den Einzeldarstellungen der Figuren 6 bis 8 gezeigt sind.

Aus dem mit Hilfe des CCD-Arrays 16 gemessenem Intensitätsprofil des Projektionslichtbündels 5 vor der Beleuchtungsoptik 6 und Sollwerten für die Beleuchtungswinkelverteilung und die Beleuchtungsintensität in der Objektebene 10 wird ein Soll-Transmissionsverlauf für das Pupillenfilter 7 berechnet. Zu dieser Berechnung, die in einem nicht dargestellten Prozessor der Steuereinrichtung 18 erfolgt, können alternativ oder zusätzlich Messdaten der Detektionseinrichtung 30 für die Beleuchtungsintensitäts- oder Beleuchtungswinkelverteilung in der Objektebene 10 herangezogen werden.

Über die Steuereinrichtung 18 wird die Antriebseinrichtung 20 so angesteuert, daß sich über die Verdrehung des drehbaren Filterelements 22' der gewünschte Transmissionsverlauf einstellt. Anschließend kann die Projektionsbelichtung erfolgen.

**Patentansprüche**

1. Projektionsbelichtungsanlage, insbesondere für die

Mikro-Lithographie, zur Erzeugung eines Bildes eines in einer Objektebene (10) angeordneten Objekts (2) in einer Bildebene (11) mit einer Projektionslicht emittierenden Lichtquelle (4), mit einer im Strahlengang zwischen der Lichtquelle (4) und der Objektebene (10) angeordneten Beleuchtungsoptik (6) und einer im Strahlengang zwischen der Objektebene (10) und der Bildebene (11) angeordneten Projektionsoptik (8), wobei in einer Filterebene, die im Bereich einer Pupillenebene (12) zwischen der Lichtquelle (4) und der Objektebene (10) liegt, ein Filter (7) mit einem beweglichen Filterelement (22) angeordnet ist, welches derart in der Filterebene beweglich ist und eine Verteilung des Transmissionsgrades über die Filterfläche derart aufweist, dass sich die Intensitätsverteilung des Projektionslichts (5) senkrecht zur optischen Achse (14) im Strahlengang nach dem Filter (7) mit der Bewegung des Filterelements (22) ändert, wobei der Transmissionsgrad des Filterelements (22) über die Filterfläche bezüglich der optischen Achse (14) der Projektionsoptik nicht rotationssymmetrisch ist, **dadurch gekennzeichnet, dass** das Filterelement (22, 22'; 122; 222; 322; 422) zumindest bereichsweise (24; 124; 224) für das Projektionslicht (5) einen Transmissionsgrad aufweist, der größer ist als 0 und kleiner ist als 100%, dass das Filterelement derart gehaltert ist, dass es um die optische Achse (14) verdreht werden kann,
dass die Projektionsbelichtungsanlage eine mit dem drehbaren
Filterelement (22') gekoppelte Antriebseinrichtung (20) und eine mit der Antriebseinrichtung (20) zusammenarbeitende Steuereinrichtung (18) hat, die abhängig von einer vorgegebenen Beleuchtungswinkelverteilung des Projektionslichts (5) in der Objektebene (10) die Antriebseinrichtung (20) zur Einstellung einer vorgegebenen Position des Filterelements (22') ansteuert, und dass mindestens eine mit der Steuereinrichtung (18) zusammenarbeitende Detektoreinrichtung (15, 16, 30) zur Erfassung der Intensitätsverteilung des Projektionslichts (5) in einer Ebene senkrecht zur optischen Achse (14) vorgesehen ist.

2. Projektionsbelichtungsanlage nach Anspruch 1,
**dadurch gekennzeichnet, dass** das Filter mindestens ein Filterelement (322, 422) mit in zur optischen Achse (14) radialer Richtung variierendem Transmissionsgrad aufweist.

3. Projektionsbelichtungsanlage nach einem der Ansprüche
1 oder 2, **dadurch gekennzeichnet, dass** das Filter ein kontinuierliches Verlaufsfilter ist.

4. Projektionsbelichtungsanlage nach einem der Anprüche
1 oder 2, **dadurch gekennzeichnet, dass** das Filterelement (22; 122; 222; 322; 422) mindestens zwei Zonen (23, 24; 123, 124; 223, 224; 330, 331, 332; 435 bis 438) mit unterschiedlichem Transmissionsgrad aufweist.

5. Projektionsbelichtungsanlage nach Anspruch 4, **dadurch**
**gekennzeichnet, dass** die freie Apertur der Beleuchtungsoptik (6) in der Filterebene (13) kreisförmig ist und dass das Filter (7; 107; 207) mindestens ein Filterelement (22, 22'; 122; 222; 322; 422) mit einer Mehrzahl von Zonen (23, 24; 123, 124; 223, 224) mit in Umfangsrichtung unterschiedlichem Transmissionsgrad aufweist.

6. Projektionsbelichtungsanlage nach Anspruch 4 oder 5,
**dadurch gekennzeichnet, dass** das Filterelement (322, 324) mindestens zwei Zonen (330, 331, 332; 435 bis 438) mit in radialer Richtung unterschiedlichem Transmissionsgrad aufweist.

7. Projektionsbelichtungsanlage nach einem der Ansprüche 4 bis 6, **dadurch gekennzeichnet, dass** das Filterelement (22, 22') vier Quadranten (23, 24) mit in Umfangsrichtung abwechselndem Transmissionsgrad aufweist.

8. Projektionsbelichtunsanlage nach einem der vorhergehenden Ansprüche, **dadurch gekennzeichnet, dass** das Filter (7; 107; 207) mindestens zwei Filterelemente (22, 22') aufweist, die derart gehaltert sind, dass sie relativ zueinander verdreht werden können.

9. Projektionsbelichtungsanlage nach Anspruch 8, **dadurch**
**gekennzeichnet, dass** in einer Relativstellung der Filterelemente (22, 22') ein rotationssymmetrischer Transmissionsgrad des Filters (7) resultiert.

10. Projektionsbelichtungsanlage nach Anspruch 1, **dadurch gekennzeichnet, dass** die Detektoreinrichtung (15, 16, 30) ein zweidimensionales CCD-Array (16) aufweist.

11. Projektionsbelichtungsanlage nach Anspruch 1 oder
10, **dadurch gekennzeichnet, dass** die Detektoreinrichtung (30) derart ausgeführt ist, dass sie die Beleuchtungswinkelverteilung des Projektionslichts (5) in der Objektebene (10) ermittelt.

**Claims**

1.  Projection exposure apparatus, especially for the microlithography, to produce in an image plane (11) an image of an object (2) arranged in an object plane (10), comprising a light source (4) emitting projection light, illumination optics (6) arranged in the ray path between the light source (4) and the object plane (10) and projection optics (8) arranged in the ray path between the object plane (10) and the image plane (11), wherein a filter (7) comprising a moveable filter element (22) is arranged in a filter plane which lies in the vicinity of a pupil plane (12) between the light source (4) and the object plane (10), wherein the filter element (22) is moveable in the filter plane and has a distribution of the transmission factor over the filter face in such a way that the intensity distribution of the projection light (5) perpendicular to the optical axis (14) in the ray path after the filter (7) changes with the movement of the filter element (22), wherein the transmission factor of the filter element (22) over the filter face is not rotation-symmetrical with respect to the optical axis (14) of the projection optics, **characterised in that** the filter element (22, 22'; 122; 222; 3,22; 422) has at least in certain areas (24; 124; 224) a transmission factor for the projection light (5) being greater than 0 and less than 100%, **in that** the filter element is retained in such a way that it can be turned around the optical axis (14),
    **in that** the projection exposure apparatus comprises a drive mechanism (20) coupled with the rotatable filter element (22') and a control device (18) acting together with the drive mechanism (20), wherein the control device (18) controls the drive mechanism (20), depending on a pre-set illumination angle distribution of the projection light (5) in the object plane (10), to adjust a pre-set position of the filter element (22'), and **in that** at least one detector device (15, 16, 30) is provided acting together with the control device (18) to detect the intensity distribution of the projection light (5) in a plane perpendicular to the optical axis (14).

2.  Projection exposure apparatus according to claim 1,
    **characterised in that** the filter has at least one filter element (322, 422) having a transmission factor varying in the radial direction to the optical axis (14).

3.  Projection exposure apparatus according to one of claims 1 or 2, **characterised in that** the filter is a continous graduated filter.

4.  Projection exposure apparatus according to one of claims 1 or 2, **characterised in that** the filter element (22; 122; 222; 322; 422) has at least two zones (23, 24; 123, 124; 223, 224; 330, 331, 332; 435 to 438) having a varying transmission factor.

5.  Projection exposure apparatus according to claim 4,
    **characterised in that** the free aperture of the illumination optics (6) in the filter plane (13) is circular and that the filter (7; 107; 207) has at least one filter element (22, 22'; 122; 222; 322; 422) comprising a multiplicity of zones (23, 24; 123, 124; 223, 224) having a transmission factor varying in the circumferential direction.

6.  Projection exposure apparatus according to claims 4 or 5, **characterised in that** the filter element (322, 324) has at least two zones (330, 331, 332; 435 to 438) having a transmission factor varying in the radial direction.

7.  Projection exposure apparatus according to one of claims 4 to 6, **characterised in that** the filter element (22, 22') has four quadrants (23, 24) having a transmission factor alternating in the circumferential direction.

8.  Projection exposure apparatus according to one of the preceding Claims, **characterised in that** the filter (7; 107; 207) has at least two filter elements (22, 22') which are retained in such a way that they can be turned in relation to each other.

9.  Projection exposure apparatus according to claim 8,
    **characterised in that** a rotation-symmetrical transmission factor of the filter (7) results in a relative position of the filter elements (22, 22').

10. Projection exposure apparatus according to claim 1,
    **characterised in that** the detector device (15, 16, 30) comprises a two-dimensional CCD array (16).

11. Projection exposure apparatus according to claims 1

or 10, **characterised in that** the detector device (30) is designed in such a way that it determines the illumination angle distribution of the projection light (5) in the object plane (10).

**Revendications**

1. Installation d'exposition par projection, en particulier pour la microlithographie, pour générer une image d'un objet (2) disposé dans un plan d'objet (10) dans un plan d'image (11), avec une source de lumière (4) émettant une lumière de projection, avec une optique d'éclairage (6) disposée dans le chemin optique entre la source de lumière (4) et le plan d'objet (10) et une optique de projection (8) disposée dans le chemin optique entre le plan d'objet (10) et le plan d'image (11), un filtre (7) avec un élément filtrant (22) mobile étant disposé dans un plan de filtre qui se situe dans la région d'un plan pupillaire (12) entre la source de lumière (4) et le plan d'objet (10), lequel élément filtrant (22) est mobile dans le plan de filtre de telle façon et présente une répartition du degré de transmission sur la surface de filtre telle que la répartition d'intensité de la lumière de projection (5) perpendiculairement à l'axe optique (14) dans le chemin optique en aval du filtre (7) varie avec le mouvement de l'élément filtrant (22), le degré de transmission de l'élément filtrant (22) sur la surface de filtre n'étant pas à symétrie de révolution par rapport à l'axe optique (14) de l'optique de projection,
   **caractérisée en ce**
   **que** l'élément filtrant (22, 22' ; 122 ; 222 ; 322 ; 422) présente au moins par endroits (24 ; 124 ; 224) pour la lumière de projection (5) un degré de transmission qui est supérieur à 0 et inférieur à 100 %,
   **que** l'élément filtrant est maintenu de façon à pouvoir être tourné autour de l'axe optique (14),
   **que** l'installation d'exposition par projection présente un dispositif d'entraînement (20) couplé à l'élément filtrant (22') tournant et un dispositif de commande (18) qui coopère avec le dispositif d'entraînement (20) et commande le dispositif d'entraînement (20) pour régler une position prédéfinie de l'élément filtrant (22') en fonction d'une répartition d'angle d'éclairage prédéfinie de la lumière de projection (5) dans le plan d'objet (10), et
   **qu'**au moins un dispositif de détection (15, 16, 30) qui coopère avec le dispositif de commande (18) est prévu dans un plan perpendiculaire à l'axe optique (14) pour détecter la répartition d'intensité de la lumière de projection (5).

2. Installation d'exposition par projection selon la revendication 1, **caractérisée en ce que** le filtre présente au moins un élément filtrant (322, 422) à degré de transmission variable en direction radiale par rapport à l'axe optique (14).

3. Installation d'exposition par projection selon une des revendications 1 ou 2, **caractérisée en ce que** le filtre est un filtre dégradé continu.

4. Installation d'exposition par projection selon une des revendications 1 ou 2, **caractérisée en ce que** l'élément filtrant (22; 122 ; 222 ; 322; 422) présente au moins deux zones (23, 24 ; 123, 124 ; 223, 224; 330, 331, 332; 435 à 438) à degré de transmission différent.

5. Installation d'exposition par projection selon la revendication 4, **caractérisée en ce que** l'ouverture libre de l'optique d'éclairage (6) dans le plan de filtre (13) est circulaire et que le filtre (7 ; 107 ; 207) présente au moins un élément filtrant (22, 22' ; 122 ; 222 ; 322 ; 422) avec une pluralité de zones (23, 24 ; 123, 124 ; 223, 224) à degré de transmission différent en direction circonférentielle.

6. Installation d'exposition par projection selon la revendication 4 ou 5, **caractérisée en ce que** l'élément filtrant (322, 324) présente au moins deux zones (330, 331, 332 ; 435 à 438) à degré de transmission différent en direction radiale.

7. Installation d'exposition par projection selon une des revendications 4 à 6, **caractérisée en ce que** l'élément filtrant (22, 22') présente quatre quadrants (23, 24) à degré de transmission alternant en direction circonférentielle.

8. Installation d'exposition par projection selon une des revendications précédentes, **caractérisée en ce que** le filtre (7 ; 107 ; 207) présente au moins deux éléments filtrants (22, 22') qui sont maintenus de façon à pouvoir être tournés l'un par rapport à l'autre.

9. Installation d'exposition par projection selon la revendication 8, **caractérisée en ce qu'**il en résulte un degré de transmission du filtre (7) à symétrie de révolution dans une position relative des éléments filtrants (22, 22').

10. Installation d'exposition par projection selon la revendication 1, **caractérisée en ce que** le dispositif de détection (15, 16, 30) présente une matrice CCD bidimensionnelle (16).

**11.** Installation d'exposition par projection selon la revendication 1 ou 10, **caractérisée en ce que** le dispositif de détection (30) est réalisé de façon qu'il détermine la répartition d'angle d'éclairage de la lumière de projection (5) dans le plan d'objet (10).

Fig. 1

EP 1 186 956 B1

**Fig. 2**

24

23

22

23

24

**Fig. 3**

332

322

331

330

**Fig. 4**

438

437

422

436

435

**14**

**23** **22**

**7**

**A**

**24**

**22'**

**A'**

**20**

**21**

**A'**

**α**

**A**

# Fig. 5

EP 1 186 956 B1

| α: | 90° | 78.75° | 67.5° | 56.25° | 45° | 33.75° | 22.5° | 11.25° | 0° |
|----|-----|--------|-------|--------|-----|--------|-------|--------|-----|

**Fig. 6**

| α: | 45° | 33.75° | 22.5° | 11.25° | 0° |
|----|-----|--------|-------|--------|-----|

**Fig. 7**

| α: | 22.5° | 11.25° | 0° |
|----|-------|--------|-----|

**Fig. 8**

EP 1 186 956 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5264898 A
- US 5329336 A
- EP 0938031 A1
- JP 9190969 A